# EUROPEAN PATENT APPLICATION

(11) **EP 4 678 481 A1**
(43) Date of publication of application: **14.01.2026**
(21) Application number: 24187010.4
(22) Date of filing: 08.07.2024
(51) Int. Cl.: B60R 16/023, B60L 3/04, B60L 3/00

(54) **A POWER DISTRIBUTION BOX WITH A LID HAVING AN INSPECTION OPENING**

(71) Applicant: Volvo Truck Corporation, 405 08 Göteborg (SE)
(72) Inventor: BERNATAVICIUS, Pijus, 437 31 LINDOME (SE); LARSSON, Johannes, 415 74 GÖTEBORG (SE); SERRA DALMAU, Albert, 416 72 GÖTEBORG (SE)
(74) Representative: Kransell & Wennborg KB

(57) **Abstract**

A power distribution box (100) for a high voltage circuit connectable to a high voltage system, the power distribution box comprising: a housing (102) for accommodating the high voltage circuit (101); a lid (104) for closing a main opening of the housing, the lid comprising an inspection opening (106) and an inspection cover (108) that is adapted to cover the inspection opening in the lid, wherein voltage measurement points (110) are accessible in the inspection opening for measuring a voltage of the high voltage circuit, wherein, the inspection cover comprises an element (112) that once the inspection cover is removed from the lid, causes shut down of the high voltage system.

## Description

### TECHNICAL FIELD

The disclosure relates generally to a voltage power box. In particular aspects, the disclosure relates to a power distribution box with a lid having an inspection opening. The disclosure can be applied to heavy-duty vehicles, such as trucks, buses, and construction equipment, among other vehicle types. The disclosure can equally well be applied to cars, marine applications, industrial applications and vehicles, and stationary applications. Although the disclosure may be described with respect to a particular vehicle, the disclosure is not restricted to any particular vehicle.

### BACKGROUND

High voltage power distribution boxes are often equipped with a slowdown lid which blocks the access to the high voltage components once an outer main lid is removed which also causes shutdown of a voltage system connected to the box and therefore the voltage in the box. The slowdown lid prevents too soon access to the high voltage components when the components in the box are powered, thereby preventing injury. The slowdown lid is removed once the voltage in the box is at zero volts. However, removal of the slowdown lid is very time consuming and troublesome.

### SUMMARY

According to a first aspect of the disclosure, there is provided a power distribution box for a high voltage circuit connectable to a high voltage system, the power distribution box comprising: a housing for accommodating the high voltage circuit; a lid for closing a main opening of the housing, the lid comprising an inspection opening and an inspection cover that is adapted to cover the inspection opening in the lid, wherein voltage measurement points are accessible in the inspection opening for measuring a voltage of the high voltage circuit, wherein the inspection cover comprises an element that once the inspection cover is removed from the lid, causes shut down of the high voltage system.

The first aspect of the disclosure may seek to reduce the time and work effort for opening a power distribution box and accessing the components therein in a safe way. A technical benefit may include that time and work effort for decommission of a power distribution box is reduced. Furthermore, accessing components in a power distribution box can be made in a more user-friendly way without compromising safety.

Optionally in some examples, including in at least one preferred example, the element may be a magnet that controls a reed switch in the housing. A technical benefit may include that a reliable contact-less way for controlling shut-down of the high voltage system is provided that ensures safety during removal of the lid.

Optionally in some examples, including in at least one preferred example, the element may be a spring or lever activator that controls a switch in the housing.

Optionally in some examples, including in at least one preferred example, the inspection cover may comprise a covering part that is adapted to cover the inspection opening and a protruding portion that is arranged to cover a fastener configured for attaching the lid to the housing. The covering part covers the fastener such that the lid cannot be removed without removing the inspection cover. That is, the fastener must be removed to open the lid of the power distribution box, however, to remove the fastener the inspection cover must first be removed. A technical benefit is that safety is improved since the inspection cover must be removed prior to the lid and removing the inspection cover causes shut down of the high voltage system.

Optionally in some examples, including in at least one preferred example, the inspection cover may comprise a rotation block element that engages with a corresponding element of the lid, the engagement providing a rotational lock for the inspection cover relative to the lid. A technical advantage may be that once the inspection cover is properly arranged, rotational motion of the inspection cover is prevented which improves safety, especially when the inspection cover includes the covering part that covers the fastener such that the lid cannot be removed without removing the inspection cover. The rotational lock prevents accidental exposure of the fastener.

Optionally in some examples, including in at least one preferred example, removing the inspection cover may cause interruption in an HVIL circuit in the power distribution box which causes shut down of a traction voltage system. A HVIL is a High Voltage Interlock Loop circuit which is configured to shut down the high voltage system when the loop circuit is interrupted.

Optionally in some examples, including in at least one preferred example, the inspection cover may comprise a sealing element that is adapted to seal the inspection opening. A technical benefit is that a risk electrical failure due to liquids and moisture that contact the voltage measurement points is reduced.

Optionally in some examples, including in at least one preferred example, the lid may comprise an inspection cavity that is arranged to extend into the housing, towards the voltage measurement points, the inspection cavity comprises through-holes through which the measurement points are accessible under the inspection cover. The inspection cavity extends into the housing when the lid is attached to the housing. The cavity with through-holes ensures that only the measurement points are accessible under the inspection cover and no other high voltage components are accessible, thereby improving safety for maintenance personnel. Furthermore, the cavity further reduces the risk of dirt and liquids reaching inside the power distribution box. The inspection cavity may be in the form of a bucket, and further prevents direct access to the high voltage components, only the measurement points can be accessed.

Optionally in some examples, including in at least one preferred example, the lid may be adapted to the attached to the housing by a set of removable fasteners. In this way, the lid may be easily removed and reattached.

Optionally in some examples, including in at least one preferred example, the inspection cover may be attached to the lid by at least one fastener. In this way, the inspection cover may be easily removed and reattached.

Optionally in some examples, including in at least one preferred example, the inspection cover may comprise a gripping member that is spaced apart from the lid by a gap to allow gripping the inspection cover for removal from the lid. A technical benefit is that removal of the lid can be made in a more user-friendly way.

Optionally in some examples, including in at least one preferred example, the measurement points may be accessible in the inspection opening for measuring a voltage of the high voltage circuit without opening the lid. This improves user-friendliness and reduces time for opening and/or decommission of the power distribution box.

Optionally in some examples, including in at least one preferred example, the inspection cover may be substantially smaller than the lid. There is no need for a large inspection cover for accessing the voltage measurements points, thereby facilitating manufacturing of the lid and inspection cover in this way.

Optionally in some examples, including in at least one preferred example, a number of fasteners used for attaching the lid to the housing may be substantially higher than the number of fasteners used for attaching the inspection cover to the lid. Reducing the number of fasteners used for attaching the inspection cover to the lid reduces the burden for inspecting and ensuring that the voltage of the high voltage system is zero before opening the main lid.

A number of fasteners used for attaching the inspection cover to the lid may be two, although one or more than two fasteners is also possible.

Optionally in some examples, including in at least one preferred example, the type of fastener for attaching the lid to the housing is different from the type of fastener used for attaching the inspection cover to the lid. For example, the screw heads may be different. A technical benefit is that this adds more time for disassembly giving more time for the high voltage system to discharge

Optionally in some examples, including in at least one preferred example, wherein the fasteners may be screws or bolts, although also, clips, studs, or nuts are possible fasteners Glue is another possible means for attaching the lid to the housing or the inspection cover to the lid.

Optionally in some examples, including in at least one preferred example, wherein the measurement points may be connected to voltage busbars inside the power distribution box.

The measurement points may be directly connected to the voltage busbars, or indirectly connected to the busbars via other electrical elements. The measurement points may be on the voltage busbars.

There is further provided a system comprising: a power distribution box according to any one of the herein described examples, a high voltage circuit accommodated in the power distribution box, wherein the high voltage circuit is connected to a traction voltage system of a vehicle.

There is further provided a vehicle comprising a power distribution box according to any one of the herein described examples, or a system according to any one of the herein described examples.

Optionally in some examples, including in at least one preferred example, the high voltage circuit is connected to a traction voltage system of the vehicle.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

### BRIEF DESCRIPTION OF THE DRAWINGS

Examples are described in more detail below with reference to the appended drawings.
**FIG. 2A** is an exemplary power distribution box according to an example.
**FIG. 2B** is an exploded view of the exemplary power distribution box in Fig 2A.
**FIG. 3** is an inspection cover according to an example.
**FIG. 4** is a lid with the inspection cover removed according to an example.
**FIG. 5** is an inspection cavity that is arranged to extend into the housing according to an example.
**FIG. 6** illustrates a system according to an example.
**FIG. 7** illustrates a vehicle according to an example.
**FIG. 8A** illustrates a power distribution box according to an example.
**FIG. 8B** illustrates a connecting side of the plug according to an example.
**FIG. 9A** illustrates a power distribution box before the plug is connected according to an example.
**FIG. 9B** illustrates a power distribution box with the plug connected according to an example.

### DETAILED DESCRIPTION

The detailed description set forth below provides information and examples of the disclosed technology with sufficient detail to enable those skilled in the art to practice the disclosure.

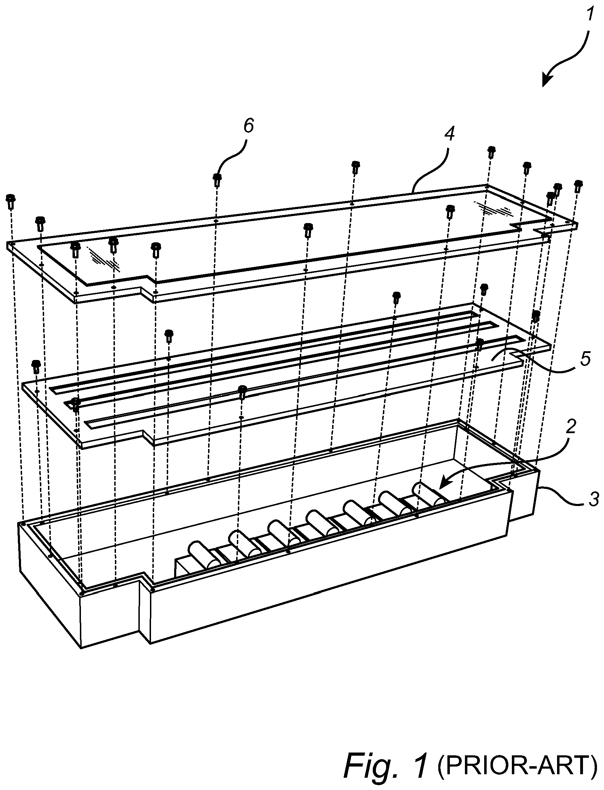

**FIG. 1** illustrates a typical prior art power distribution box 1 that accommodates high voltage electrical components 2 in its housing 3. The housing 3 can be closed by a main lid 4 and a slowdown lid 5. The main lid 4 goes on top of the slowdown lid 5 such that for opening the box 1, the main lid is first removed followed by removal of the slowdown lid. Removal of the main lid 4 cause power shutdown inside the box 1 and the time duration for removal of the slowdown lid 5 ensures that the voltage inside the box 1 has reached zero before the components 2 inside the box is accessible from outside the box 1. Furthermore, to access measurement points for measuring the voltage in the box, the main lid must first be removed.

However, removal of the main lid 4 requires detachment of a vast number of screws 6 which is both time-consuming and troublesome. This drawback of prior art is addressed by examples presented herein.

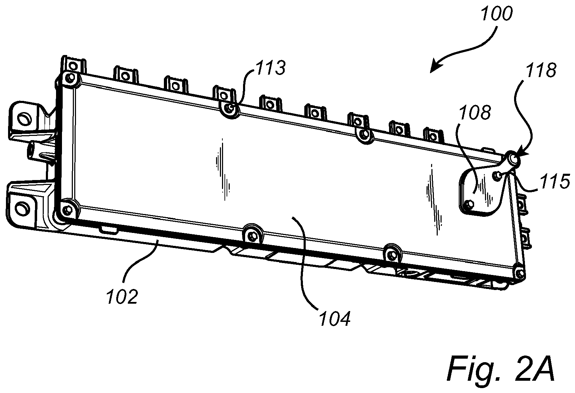

**FIG. 2A** is an exemplary power distribution box 100 for a high voltage circuit 101 connectable to a high voltage system according to an example.

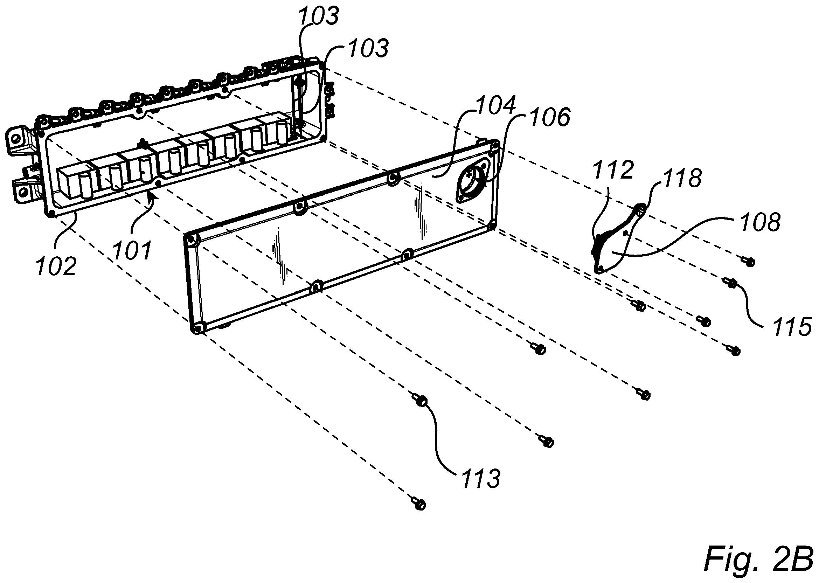

**FIG. 2B** is an exploded view of the power distribution box 100.

The power distribution box 100 comprises a housing 102 that accommodates the high voltage circuit 101. The high voltage circuit 101 is connected to busbars 103 inside the housing 102 that connects the high voltage circuit 101 to the high voltage system, which in some examples may be a traction voltage system for an at least partly, or fully, electric vehicle.

The power distribution box 100 comprises a lid 104 for closing a main opening 105 of the housing 102. The lid 104 comprises an inspection opening 106 and an inspection cover 108 that is adapted to cover the inspection opening 106 in the lid 104. Once the inspection cover 108 is removed voltage measurement points 110 connected with the busbars 103 are accessible in the inspection opening 106 for measuring a voltage of the high voltage circuit 101. The measurement points 110 may be directly on the busbars 103 or via a connector. The measurement points 110 may be via direct access to the busbars once the inspection cover 108 is removed.

The inspection cover 108 comprises an element 112 that once the inspection cover 108 is removed from the lid 104, causes shutdown of the high voltage system.

The lid 104, which may be considered a main lid for the housing 102, is attached to the housing 102 by a set of fasteners 113, such as screws or bolts. Similarly, the inspection cover 108 is attached to the lid 104 by at least one fastener 115, such as at least one screw or bolt.

A number of fasteners 113 used for attaching the lid 104 to the housing 102 is substantially higher than a number of fasteners 115 used for attaching the inspection cover 108 to the lid. In this particular example, the number of fasteners 115 used for attaching the inspection cover 108 to the lid 104 is two and the number of fasteners 113 used for attaching the lid 104 to the housing 104 is eight. The type of fastener for attaching the lid 104 to the housing 102 may be different from the type of fastener used for attaching the inspection cover 108 to the lid 102, for example by means of different screw heads.

The lid 104 is adapted to cover the entire main opening 105 of the housing 102. The inspection cover 108 only needs to cover the much smaller inspection opening 106 that only needs to accommodate for the voltage measurements points 110. Therefore, the inspection cover is smaller than the lid 104, or even substantially smaller than the lid 104, such as about 10%, or 15%, or 20% of the size of the lid 104.

With the power distribution box 100 only the small inspection cover 108 needs to be removed to access voltage measurements points 110 so that a measurement can confirm the shutdown of the high voltage system before the main lid 104 is removed from the housing 102.

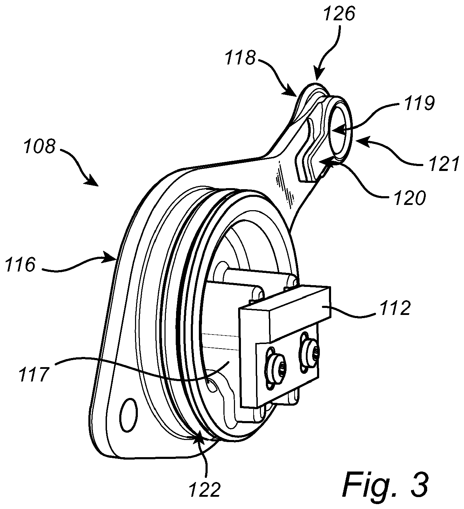

**FIG. 3** illustrates the inspection cover 108 in more detail.

On the inside of the inspection cover 108, facing inwards to the inspection opening 106, is the element 112 that, once removed causes shutdown of the high voltage system. The element 112 is screwed to an inside structure 117 of the inspection cover 108. The element 112 is in this example a magnet 112 that controls a reed switch in the housing 102. A reed switch is an electromechanical switch that is operated by a magnetic field. The magnetic field produced by the magnet 112 cause the reed switch to open the circuit is controls, which in this example is a high voltage interlock loop circuit, HVIL circuit of the high voltage system. Opening the HVIL circuit cause shutdown of the high voltage system.

In other examples, the element may be a spring or lever activator that controls a switch in the housing 102.

The inspection cover 108 further comprising a sealing element 122 such as an O-ring that is adapted to seal the inspection opening 106.

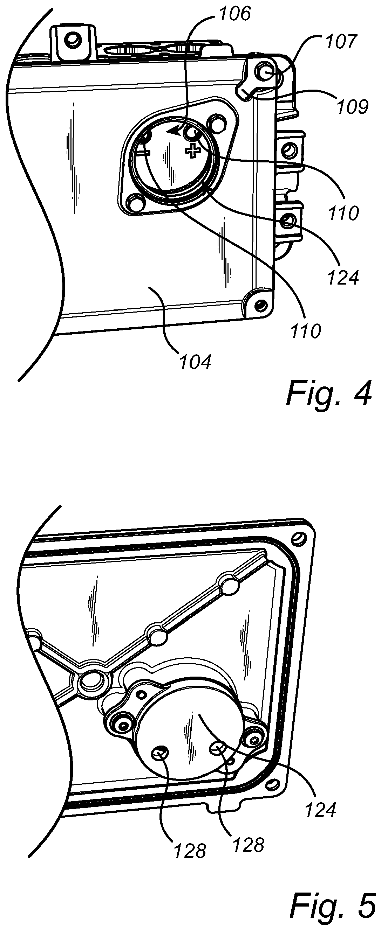

The inspection cover 108 comprises a covering part 116 which is adapted to cover the inspection opening 106. A shape of the covering part 116 matches that of the inspection opening 106 so that the O-ring seals the opening 106, better seen in **FIG. 4****.** Furthermore, the inspection cover comprises a protruding portion 118 that is arranged to cover a fastener 107 configured for attaching the lid 104 to the housing such that the lid 104 cannot be removed without removing the inspection cover 108.

**FIG. 4** illustrates the lid 104 with the inspection cover 108 removed according to an example. The fastener 107 is exposed by removing the inspection cover 108. When the inspection cover 108 is attached to the lid in its intended position, see fig. 1, the fastener 107 is hidden under the protruding portion 118 and cannot be accessed. In other words, to access the fastener 107, as required for removing the main lid 104, the inspection cover 108 must be removed which causes shutdown of the high voltage system due to the reed switch opening the HVIL circuit. The voltage of the busbars can be measured at the exposed voltage measurement points 110 under the inspection cover 108. The protruding portion 118 comprises an opening 119 or cavity on its distal end 121 in which the head of the fastener 107 is accommodated and covered.

The inspection cover 108 is a small lid in the larger lid 104 and provides a so-called poka-yoke mechanism where in order to remove the main lid 104, the smaller inspection lid needs to be removed first to access the screw 107, which causes the high voltage system to shut down.

The inspection cover 108 comprises a rotation block element 120 that engages with a corresponding element 109 of the lid 104. The engagement provides a rotational lock for the inspection cover 108 relative to the lid 104. In this example, the rotation block element 120 is a protruding structure with a shape that fits in and matches an opening 109 or cavity 109 in the lid 104. The shape of the rotation block element 120 and the opening 109 may be non-circular such that once the rotational block element 120 is fitted and maintained in the opening 109, the rotational block element 120 cannot be rotated relative to the opening 109. Overall, this prevents the inspection cover 108 from rotating with respect to the opening 106, and maintains the inspection cover 108 in place in the inspection opening 106 until removed by pulling it upwards away from the inspection opening 106.

To facilitate removal of the inspection cover 108 the inspection cover comprises a gripping member 126 that is spaced apart from the lid 104 by a gap to allow gripping the inspection cover for removal from the lid. This gripping surface provides for easier removal of the inspection cover 108. The gripping member 126 may be provided in the form of an upper flange 126 on the protruding portion 118 of the inspection cover 108.

The measurement points 110 are accessible in the inspection opening 106 for measuring a voltage of the high voltage circuit without opening the lid 104. That is, the lid 104 is still attached to the housing 102, protecting a user from the high voltage components inside the housing 102, when confirming that the voltage of the busbar inside the housing 102 by measuring the voltage at the measurement points 110.

**FIG. 5** illustrates a side of the lid 104 facing into the housing 102. The lid comprises an inspection cavity 124 that is arranged to extend into the housing when lid 104 is attached to the housing. The inspection cavity 124 reaches, towards the voltage measurement points and comprises through-holes 128 through which the measurement points 110 are accessible under the inspection cover 108. The cavity 124 or equally termed bucket 124 accommodates the element 112 when the inspection cover 108 is attached in the inspection opening 106. The inspection cavity 124 or bucket prevents direct access to the high voltage components, only the measurement points 110 can be accessed. That is, Inspection cavity acts as insulation layer to obstruct access to HV parts when measuring the voltage at the voltage measurement points 110 which are only accessible with probes not fingers.

The inspection cavity 124 or bucket is made from a non-conducting material such as plastic.

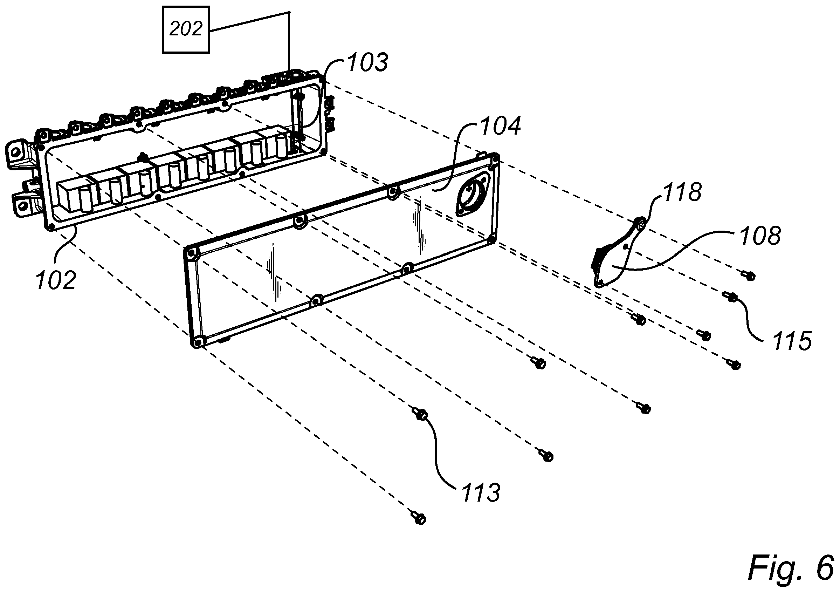

**FIG. 6** illustrates a system 200 comprising power distribution box 100, and a high voltage circuit 101 accommodated in the power distribution box, wherein the high voltage circuit is connected to a traction voltage system 202 of a vehicle.

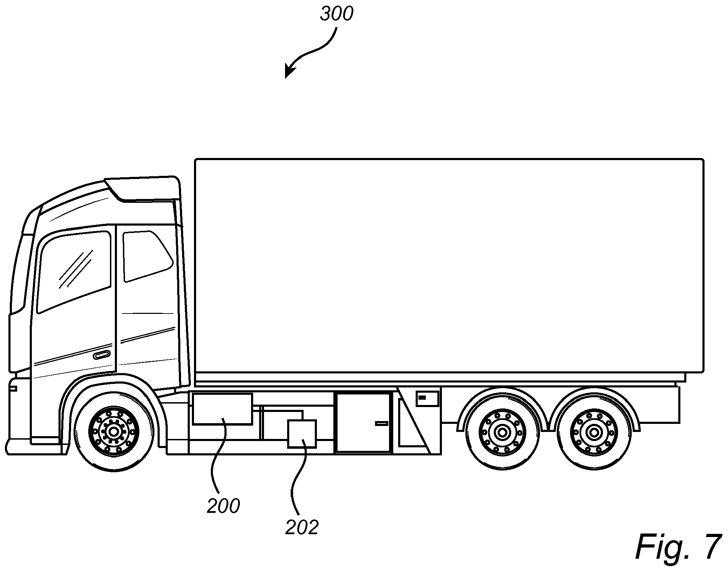

**FIG. 7** illustrates a vehicle 300 comprising a power distribution box 100 or a system 200. The high voltage circuit 101 is connected to a traction voltage system 202 of the vehicle.

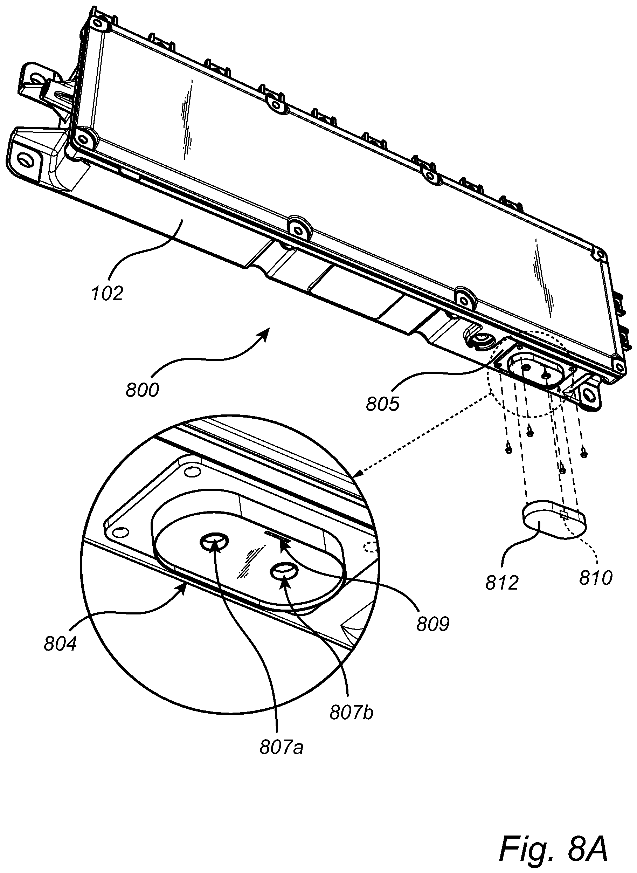

**FIG. 8A** illustrates a power distribution box 800 for a high voltage circuit 101 connectable to a high voltage system 202. The power distribution box 800 comprises a connector 804 on an exterior surface 805 of the power distribution box. The connector 804 comprises voltage measurement points 807a, 807b, electrically connected to a busbar 103 inside the box, and shutdown terminals 809, and a plug 812 comprising an element 810 that closes or connects the shutdown terminals 809 when the plug is attached to the connector 804 for covering the voltage measurement points 807a and 807b and the shutdown terminals 809. Once the plug 812 is removed from the connector 804, the shutdown terminals disconnect from each other, and causes shut down of the high voltage system 202.

Preferably, the shutdown terminals are HVIL terminals of the high voltage system.

The voltage measurement points 807a-b may be jack type terminals.

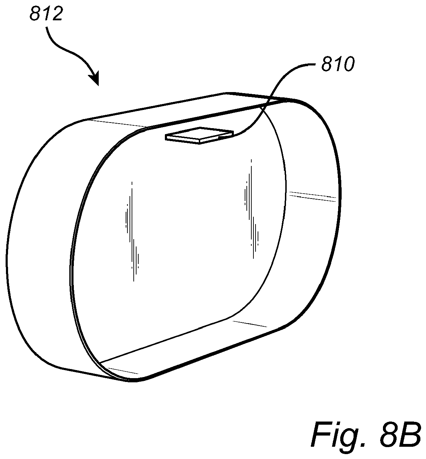

**FIG. 8B** illustrates the connecting side of the plug 812 with the element 810 that connects to the shutdown terminals 809.

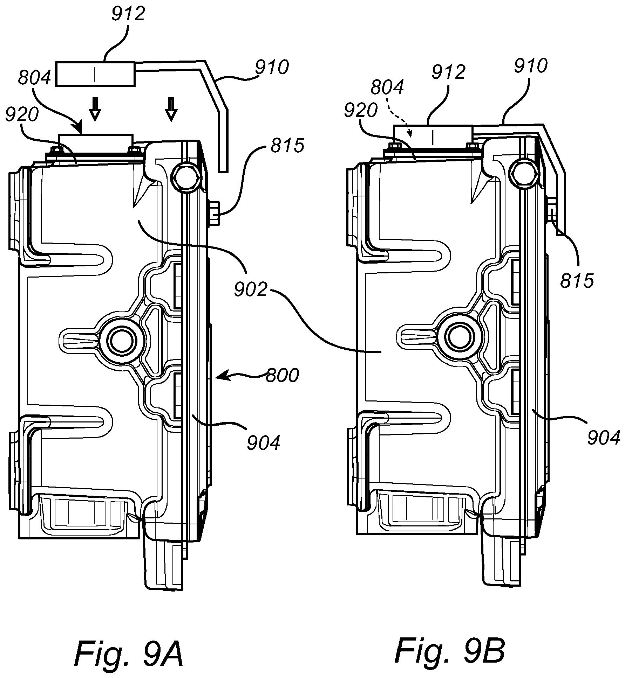

**FIG. 9A** illustrates the power distribution box 800 a plug 912 according to an example. The power distribution box comprises a housing 902 for accommodating the high voltage circuit 101, and a lid 904 for closing a main opening of the housing 902. The lid 904 is attachable to the housing by fasteners of which one fastener 815 is shown in fig. 9A. The plug 912 comprises a protrusion 910 or arm 910 that extends to cover a fastener 815 of the main lid when the plug being attached to the connector 804.

As shown in **FIG. 9B****,** the connector 804 is arranged in a side surface 920 of the housing 902, and the protrusion 910 of the plug 912 extends from the side surface to the fastener 815 on the lid 904 on top of the 902 housing.

To open the lid 904, that is, to remove the lid 904 from the housing 902 to access the high voltage circuit inside the housing, the fastener 815 must be removed. To remove the fastener 815, the protrusion 910 or arm 910 must be moved away from the fastener 815, which means the plug 912 must be removed which disconnects the shutdown terminals 809 and therefore opens the HVIL circuit. The high voltage system is then shut down, which can be confirmed by measuring the voltage across the voltage measurement points 807a and 807b accessible once the plug 912 is removed.

Example 1: A power distribution box for a high voltage circuit connectable to a high voltage system, the power distribution box comprising: a housing for accommodating the high voltage circuit; a lid for closing a main opening of the housing, the lid comprising an inspection opening and an inspection cover that is adapted to cover the inspection opening in the lid, wherein voltage measurement points are accessible in the inspection opening for measuring a voltage of the high voltage circuit, wherein, the inspection cover comprises an element that once the inspection cover is removed from the lid, causes shut down of the high voltage system.

Example 2: The power distribution box according to example 1, wherein the element is a magnet that controls a reed switch in the housing.

Example 3: The power distribution box according to any of examples 1-2, wherein the inspection cover comprises a covering part that is adapted to cover the inspection opening and a protruding portion that is arranged to cover a fastener configured for attaching the lid to the housing.

Example 4: The power distribution box according to any of examples 1-3, the inspection cover comprising a rotation block element that engages with a corresponding element of the lid, the engagement providing a rotational lock for the inspection cover relative to the lid.

Example 5: The power distribution box according to any of examples 1-4, wherein removing the inspection cover causes interruption in an HVIL circuit in the high power voltage box which causes shut down of a traction voltage system.

Example 6: The power distribution box according to any of examples 1-5, the inspection cover comprising a sealing element that is adapted to seal the inspection opening.

Example 7: The power distribution box according to any of examples 1-6, the lid comprises an inspection cavity that is arranged to extend into the housing, towards the voltage measurement points, the inspection cavity comprises through-holes through which the measurement points are accessible under the inspection cover.

Example 8: The power distribution box according to any of examples 1-7, the lid is adapted to the attached to the housing by a set of removable fasteners.

Example 9: The power distribution box according to any of examples 1-8, wherein the inspection cover is attached to the lid by at least one fastener.

Example 10: The power distribution box according to any of examples 1-9, wherein the inspection cover comprises a gripping member that is spaced apart from the lid by a gap to allow gripping the inspection cover for removal from the lid.

Example 11: The power distribution box according to any of examples 1-10, wherein the measurement points are accessible in the inspection opening for measuring a voltage of the high voltage circuit without opening the lid.

Example 12: The power distribution box according to any of examples 1-11, wherein the inspection cover is substantially smaller than the lid.

Example 13: The power distribution box according to any of examples 1-12, wherein a number of fasteners used for attaching the lid to the housing is substantially higher than a number of fasteners used for attaching the inspection cover to the lid.

Example 14: The power distribution box according to example 13, wherein number of fasteners used for attaching the inspection cover to the lid is at least two.

Example 15: The power distribution box according to any one of examples 13-14, the type of fastener for attaching the lid to the housing is different from the type of fastener used for attaching the inspection cover to the lid..

Example 16: The power distribution box according to any one of examples 13-15, wherein the fasteners are screws or bolts, glue, clips, studs, or nuts.

Example 17: The power distribution box according to any of examples 1-16, wherein the measurement points are connected to voltage busbars inside the power distribution box.

Example 18: A system comprising: power distribution box according to any one of examples 1-17, and a high voltage circuit accommodated in the power distribution box, wherein the high voltage circuit is connected to a traction voltage system of a vehicle.

Example 19: A vehicle comprising a power distribution box according to any one of examples 1-17 or a system according to example 18.

Example 20: The vehicle according to example 19, wherein the high voltage circuit is connected to a traction voltage system of the vehicle.

Example 21: A power distribution box for a high voltage circuit connectable to a high voltage system, the power distribution box comprising: a connector on an exterior surface of the power distribution box, the connector comprises voltage measurement points electrically connected to a power supply busbar inside the housing and shutdown terminals, and a plug comprising an element that closes or connects the shutdown terminals when the plug is attached to the connector for covering the voltage measurement points and the shutdown terminals, wherein once the plug is removed from the connector, the shutdown terminals disconnect from each other and causes shut down of the high voltage system.

Example 22: The power distribution box according to example 21, wherein the shutdown terminals are HVIL terminals of the high voltage system.

Example 23: The power distribution box according to any one of examples 21-22, wherein the voltage measurement points are jack type terminals.

Example 24: The power distribution box according to any one of examples 21-23, comprising a housing for accommodating the high voltage circuit; and a lid for closing a main opening of the housing, the lid being attachable to the housing by fasteners, wherein the plug comprises a protrusion that extends to cover a fastener of the main lid when the plug being attached to the connector.

Example 25: The power distribution box according to example 24, wherein the connector is arranged in a side surface of the housing, and the protrusion of the plug extends from the side surface to the fastener on the lid on top of the housing.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1. A power distribution box (100) for a high voltage circuit connectable to a high voltage system, the power distribution box comprising:
a housing (102) for accommodating the high voltage circuit (101);
a lid (104) for closing a main opening of the housing, the lid comprising an inspection opening (106) and an inspection cover (108) that is adapted to cover the inspection opening in the lid, wherein voltage measurement points (110) are accessible in the inspection opening for measuring a voltage of the high voltage circuit, wherein,
the inspection cover comprises an element (112) that once the inspection cover is removed from the lid, causes shut down of the high voltage system.

2. The power distribution box according to claim 1, wherein the element is a magnet that controls a reed switch in the housing, or a spring or lever activator that controls a switch in the housing.

3. The power distribution box according to any of claims 1-2, wherein the inspection cover comprises a covering part (116) that is adapted to cover the inspection opening and a protruding portion (118) that is arranged to cover a fastener (107) configured for attaching the lid to the housing.

4. The power distribution box according to any of claims 1-3, the inspection cover comprising a rotation block element (120) that engages with a corresponding element (109) of the lid, the engagement providing a rotational lock for the inspection cover relative to the lid.

5. The power distribution box according to any of claims 1-4, wherein removing the inspection cover causes interruption in an HVIL circuit in the high power voltage box which causes shut down of a traction voltage system.

6. The power distribution box according to any of claims 1-5, the inspection cover comprising a sealing element (122) that is adapted to seal the inspection opening.

7. The power distribution box according to any of claims 1-6, the lid comprises an inspection cavity (124) that is arranged to extend into the housing, towards the voltage measurement points, the inspection cavity comprises through-holes through which the measurement points (110) are accessible under the inspection cover.

8. The power distribution box according to any of claims 1-7, the lid is adapted to the attached to the housing by a set of removable fasteners.

9. The power distribution box according to any of claims 1-8, wherein the inspection cover is attached to the lid by at least one fastener.

10. The power distribution box according to any of claims 1-9, wherein the inspection cover comprises a gripping member (126) that is spaced apart from the lid by a gap to allow gripping the inspection cover for removal from the lid.

11. The power distribution box according to any of claims 1-10, wherein the measurement points are accessible in the inspection opening for measuring a voltage of the high voltage circuit without opening the lid.

12. The power distribution box according to any one of claims 1-14, wherein the type of fastener for attaching the lid to the housing is different from the type of fastener used for attaching the inspection cover to the lid.

13. A system (200) comprising:
power distribution box according to any one of claims 1-12, and
a high voltage circuit accommodated in the power distribution box, wherein the high voltage circuit is connected to a traction voltage system of a vehicle.

14. A vehicle (300) comprising a power distribution box according to any one of claims 1-12 or a system according to claim 13.

15. The vehicle according to claim 14, wherein the high voltage circuit is connected to a traction voltage system of the vehicle.
